# EUROPEAN PATENT SPECIFICATION

(11) **EP 1 921 111 B1**
(45) Date of publication and mention of the grant of the patent: **12.04.2017**
(21) Application number: 06796684.6
(22) Date of filing: 23.08.2006
(51) Int. Cl.: C08L 63/00, C08L 33/12, H01L 21/52, C08G 59/62

(54) **EPOXY RESIN COMPOSITION AND DIE BONDING MATERIAL COMPRISING THE COMPOSITION**
EPOXIDHARZZUSAMMENSETZUNG UND DIE ZUSAMMENSETZUNG UMFASSENDES CHIPMONTAGEMATERIAL
COMPOSITION DE RÉSINE ÉPOXY ET MATÉRIAU DE FIXAGE DE MATRICE COMPRENANT LA COMPOSITION

(30) Priority: 02.09.2005 JP 2005254525
(43) Date of publication of application: 14.05.2008
(73) Proprietor: Shin-Etsu Chemical Company, Ltd., Tokyo 100-0004 (JP)
(72) Inventor: HONDA, Tsuyoshi, Annaka-shi, Gunma 3790224 (JP); TAKENAKA, Hiroyuki, 671-1104 Hyogo (JP)
(74) Representative: Pistolesi, Roberto
(86) International application number: PCT/JP2006/316521
(87) International publication number: WO 2007/029504

(56) References cited:
- GB-A- 2 086 134
- JP-A- 07 224 144
- JP-A- 07 273 140
- JP-A- 09 053 001
- JP-A- 10 237 196
- JP-A- 10 287 792
- JP-A- 61 099 356
- US-A1- 2002 089 071
- US-A1- 2004 110 010

## Description

### FIELD OF THE INVENTION

It is described, and is not an object of the present invention, an epoxy resin composition which is stable in B-stage. It is also described, and is not an object of the present invention, an epoxy resin which can be cured during a wire bonding process and so on. These epoxy resins are suitable as die bonding agents used for production of semiconductor devices.

The present invention relates to a method of producing a semiconductor device, comprising steps of
1) applying a die bonding agent comprising a composition comprising an epoxy resin composition on a substrate,
2) heating the applied die bonding agent at a temperature of from T1 to (T2-20°C) to bring the die bonding agent to a B-stage,
3) placing a semiconductor element on the die bonding agent in the B-stage, and
4) curing the die bonding agent.

### BACKGROUND OF THE INVENTION

An epoxy resin is used for various applications because of its excellent adhesion capability, resistance to heat and moisture. Particularly, a liquid epoxy resin is applicable for devices of complicated and fine designs, so that the use thereof is increasing in the production of semiconductor devices of which miniaturization and process capability speeding-up is pursued. On the other hand, factors affecting handling property of the liquid epoxy resin, for example, viscosity or flow property tend to change, which requires careful handling in its application. A typical example of such application is a die bonding agent used for bonding a chip to a substrate.

Recently, a chip becomes bigger and bigger to speeding-up its process capability and increase a degree of integration. To improve a degree of integration, stacking of a plurality of chips is pursued. A die bonding agent is thus required to be able to more accurately and efficiently bond a big chip or stacked chips. A die bonding agent commonly used these days contains a liquid epoxy resin, inorganic filler such as silica and alumina, and electrically conductive filler such as silver powder. The die bonding agent is applied or printed on a substrate and then a chip is bonded on the applied die bonding agent. However, it is difficult to bond a big chip or multi-layered chips accurately and efficiently, and problems tend to occur such as formation of voids, big fillets and shifting or displacement of a silicon die.

To solve these problems, it has been proposed to bond a chip on a semi-cured liquid epoxy resin applied on a substrate by heating the epoxy resin at a relatively low temperature to deprive the resin of its fluidity, i.e., to make the resin B-stage. There are two methods for bringing a die bonding agent to B-stage: (1) heating a die bonding agent in such a way that a curing reaction starts and, then, is forced to stop halfway through and (2) incorporating in a die bonding agent an additional reaction system which can be cured at a lower temperature than an epoxy resin and effecting B-stage by curing the reaction system, as described in the Published Japanese Translation of PCT Application No.2005-513192. The method (1) is applicable to many reaction systems easily, but obtained B-stage is not so stable. The method (2) can be applied to limited number of reaction systems, and obtained B-stage is not so stable. Here, being stable in B-stage means that a die bonding agent in B-stage maintains, during storage, chemical and physical properties of the time immediately after the agent became B-stage. A die bonding agent without stability in B-stage cannot be stored, resulting in decrease in production yield of semiconductor devices.

Document US2004/0110010 A1 discloses a b-stageable die bonding composition comprising an epoxy resin, an epoxy curing agent, a particulate thermoplastic as impact improver, an epoxy curing promoter, a silica filler (examples 5 and 6).

After a chip is bonded to a B-stage die bonding agent, the die bonding agent is cured completely to become C-stage. If cured insufficiently, substances not incorporated in a polymer network evaporate in the subsequent processes such as wire bonding and resin encapsulation processes, which may cause voids to degrade reliability of a device. Therefore, a die bonding agent is desired which does not incur voids even when curing reaction thereof is allowed to proceed in the wire bonding and resin encapsulation processes.

### SUMMARY OF THE INVENTION

It is described, and is not an object of the present invention, an epoxy resin composition which is stable in B-stage, and a die bonding agent for semiconductor devices which agent comprises the composition.

It is described, and is not an object of the present invention, a composition comprising
(A) an epoxy resin,
(B) an epoxy resin curing agent in such an amount that an equivalent ratio of a functional group of the epoxy resin curing agent (B) to the epoxy group of the epoxy resin (A) ranges from 0.8 to 1.25,
(C) thermoplastic resin particles which are solid at 25 deg. C in an amount of from 3 to 60 parts by weight per total 100 parts by weight of the epoxy resin (A) and the epoxy resin curing agent (B), and
(D) an epoxy resin curing promoter in an amount of from 0.1 to 10 parts by weight per total 100 parts by weight of the epoxy resin (A) and the epoxy resin curing agent (B). Preferably, the thermoplastic resin particles (C) are particles of a thermoplastic resin selected from the group consisting of methacrylic resins, phenoxy resins, butadiene resins, polystyrenes, and copolymers thereof, and have a molecular weight and particle size in specific ranges.

The aforesaid composition is excellent in storage stability in B-stage to improve production yield of semiconductor devices. The composition, when treated in advance to have adjusted volatiles and viscosity, can form a cured product with no or little voids even when it is cured in wire bonding and resin encapsulation processes.

The present invention relates to a method of producing a semiconductor device, comprising steps of
1) applying on a substrate a die bonding agent comprising a composition comprising
   (A) an epoxy resin,
   (B) an epoxy resin curing agent in such an amount that an equivalent ratio of a functional group of the epoxy resin curing agent (B) to the epoxy group of the epoxy resin (A) ranges from 0.8 to 1.25,
   (C) thermoplastic resin particles which are solid at 25°C in an amount of from 3 to 60 parts by weight per total 100 parts by weight of the epoxy resin (A) and the epoxy resin curing agent (B), and
   (D) an epoxy resin curing promoter in an amount of from 0.1 to 10 parts by weight per total 100 parts by weight of the epoxy resin (A) and the epoxy resin curing agent (B),
   wherein the composition, when analyzed by differential scanning calorimetry (DSC), shows at least one exothermic peak at a temperature lower than a temperature of an exothermic peak caused by curing of the epoxy resin (A), an apex temperature (T1) of said exothermic peak at the lower temperature being 80°C or higher and lower than an apex temperature (T2) of the exothermic peak caused by the curing of the epoxy resin (A) by at least 70°C, said DSC analysis being performed by heating an aluminum cell containing the composition and an empty aluminum cell as a reference at a temperature rise rate of 10°C/min from 25°C to 300°C in air,
2) heating the applied die bonding agent at a temperature of from T1 to (T2-20°C) to bring the die bonding agent to a B-stage,
3) placing a semiconductor element on the die bonding agent in the B-stage, and
4) curing the die bonding agent.

### BRIEF DESCRIPTION OF THE DRAWINGS

Fig.1 is a DSC thermogram of the composition prepared in Example 1;
Fig. 2 is a cross sectional view of a test piece prepared in Examples which comprises a bonded silicon chip;
Fig.3 is a conceptual diagram showing voids and fillets; and
Fig. 4 is a cross sectional view of an encapsulated semiconductor test piece prepared in Examples.

### PREFERRED EMBODIMENT OF THE INVENTION

### (A) Epoxy resin

As the epoxy resin (A) in the present invention, a known epoxy resin can be used. Examples of the epoxy resin include novolac type, bisphenol type, biphenyl type, phenolaralkyl type, dicyclopentadiene type, naphthalene type, amino group-containing type, and silicone-modified type epoxy resins, and a mixture of these epoxy resins. Among these, bisphenol-A type, bisphenol-F type and silicone-modified type epoxy resins are preferred. Preferably, an epoxy resin which is liquid at 25 °C, more preferably, the one having a viscosity of 100 Pa·s or smaller, particularly 10 Pa·s or smaller, at 25 °C is used.

### (B)Epoxy resin curing agent

As the curing agent (B), known curing agents can be used such as phenolic resins, after-mentioned silicone modified phenolic reins, acid anhydrides, and amines. Among these, the phenolic resins and silicone modified-phenolic resins are preferred for the reason that a well-balanced curing property and B-stage stability can be attained. Examples of the phenolic resins include novolac type, bisphenol type, trishydroxyphenylmethane type, naphthalene type, cyclopentadiene type, phenolaralkyl type phenolic resins and a mixture thereof, among which novolac type and bisphenol type phenolic resins are preferred. The phenolic resin preferably has a viscosity of 10 Pa·s or smaller, particularly 1 Pa·s or smaller, at 100 °C.

Preferably, at least a part of the epoxy resin (A) or the curing agent(B), particularly the phenolic resin, is a silicone-modified resin having a silicone residue in a molecule. An example of the silicone-modifiedresin is a copolymer prepared by reacting an aromatic polymer with an organopolysiloxane. Examples of the aromatic polymers are those represented by the following formula(3) and (4): 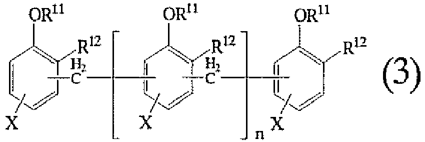 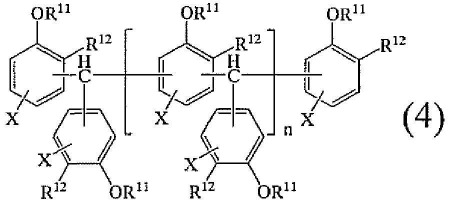 wherein R¹¹ is a hydrogen atom in a phenolic resin or an oxyrane group shown below in an epoxy resin;

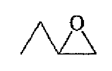

R¹² is a hydrogen atom or a methyl group, X is a hydrogen atom or a bromine atom, n is an integer of 0 or greater, preferably of from 0 to 50, particularly from 1 to 20.

Other examples of the aromatic polymers are those having an alkenyl group as represented by the following formulas (5) to (8): 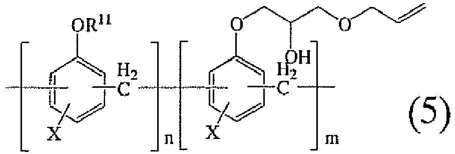 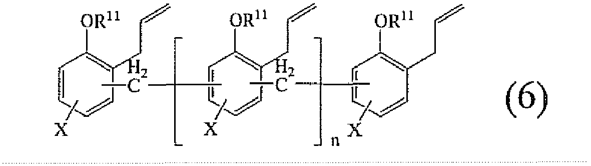 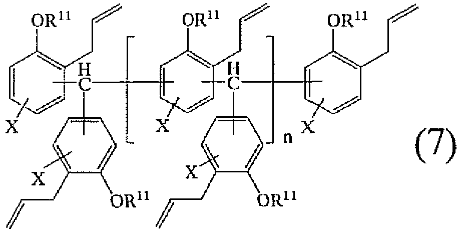 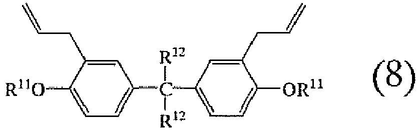 wherein R¹¹, R¹², X and n are as defined above, m is an integer of 0 or larger, preferably of from 0 to 5, particularly 0 or 1.

The organosiloxane to be reacted with the aforesaid aromatic polymer is represented by the following formula (9):

(R¹³)ₐ(R¹⁴)_{b}SiO_{(4-a-b)/2} (9)

wherein R¹³ is a hydrogen atom, an organic group having an amino, epoxy, hydroxyl, or carboxyl group, or an alkoxy group, R¹⁴ is a substituted or non-substituted monovalent hydrocarbon group, hydroxyl, alkoxy, or alkenyloxy group, a is a number of from 0.001 to 1, and b is a number of from 1 to 3, with a+b ranging from 1 to 4. One molecule of the organosiloxane contains 1 to 1,000 silicon atoms and at least one R¹³ bonded to a silicon atom.

Examples of the organic group having an amino group as R¹³ include the following groups, wherein c is 1, 2 or 3.

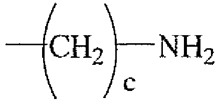

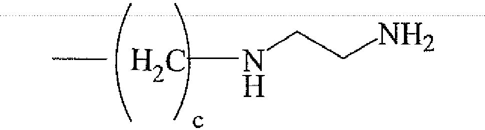

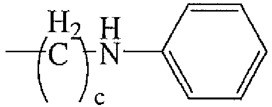

Examples of the organic group having an epoxy group include the following groups.

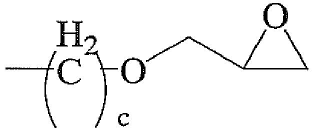

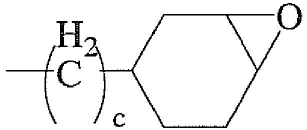

Examples of the organic group having a hydroxyl group include the following groups, wherein d is 0, 1, 2, or 3 and e is 1, 2, or 3.

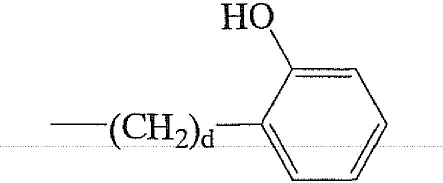

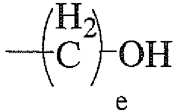

An example of the organic group having a carboxyl group is the following one, wherein f is an integer of from 1 to 10.

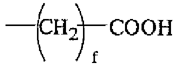

Examples of the alkoxy group include those having 1 to 4 carbon atoms such as methoxy, ethoxy, and n-propoxy group.

Preferred examples of R¹⁴, a substituted or non-substituted monovalent, include monovalent group having 1 to 10 carbon atoms, for example, C₁₋₁₀ alkyl groups such as methyl, ethyl, n-propyl, isopropyl, n-butyl, isobutyl, tert-butyl, pentyl, neopentyl, hexyl, cyclohexyl, octyl, and decyl groups; alkenyl groups such as vinyl, allyl, propenyl, and butenyl groups; aryl groups such as phenyl and tolyl groups; aralkyl groups such as benzyl and phenylethyl groups; and partly or fully halogenated groups thereof.

In the formula (9), a and b are as defined above, preferably a ranges from 0.01 to 0.1 and b ranges from 1.8 to 2, with a+b ranging from 1.85 to 2.1. The number of silicon atoms preferably ranges from 2 to 400, particularly 5 to 200. Examples of such organopolysiloxane are those represented by the following formulas (10) and (11): 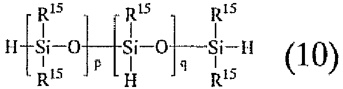 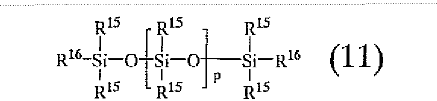 wherein R¹⁶ corresponds to R¹³ of the formula (9), i.e., a monovalent organic group having an amino, epoxy, hydroxyl, or carboxyl group; R¹⁵ corresponds to R¹⁴, i.e., a substituted or non-substituted monovalent hydrocarbon group, preferably methyl or phenyl group; p is an integer of from 0 to 1000, preferably from 3 to 400, and q is an integer of from 0 to 20, preferably from 0 to 5.

Examples of such organopolysiloxane are as shown below.

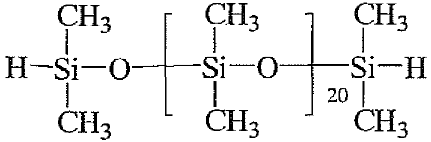

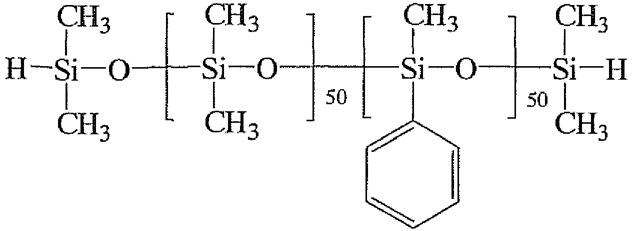

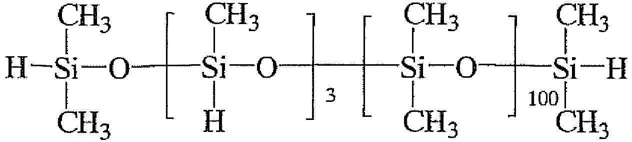

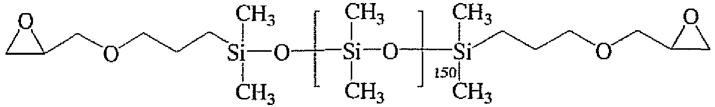

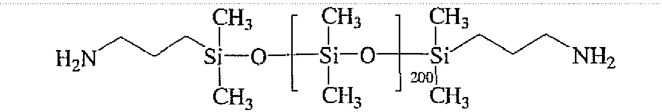

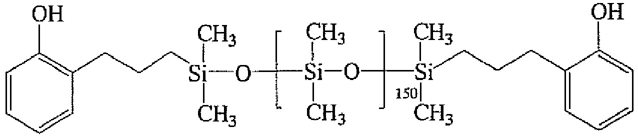

The organopolysiloxane of the formula (9) preferably has a molecular weight of from 100 to 100,000. Such an organopolysiloxane tends to form a homogeneous molecular structure, where the organopolysiloxane moieties are homogeneously dispersed in an aromatic polymer matrix, or a sea-island structure where an organopolysiloxane phase is separated from a matrix phase, depending on molecular weight and structure of the aromatic polymer to be reacted with the organopolysiloxane.

The organopolysiloxane having a relatively low molecular weight, particularly the one having a molecular weight of from 100 to 10,000, tends to form the homogeneous structure, whereas the one having a relatively high molecular weight, particularly of from 1,000 to 100,000 tends to form the sea-island structure. It is determined depending on an intended use of the composition which structure is to be selected. An organopolysiloxane having a molecular weight smaller than 100 is not preferred because it tends to give a composition which forms a hard and brittle cured product. The one having a molecular weight larger than 100,000 is not preferred either, because it tends to form a coarse see-island structure which may cause local stresses in a cured product.

The reaction between the aromatic polymer and the organopolysiloxane can be performed according to a known method, for example, an addition reaction using a platinum catalyst.

In the described composition, a mixing ratio of the epoxy resin (A) to a curing agent (B), as an equivalent ratio of the epoxy group to a functional group reactive with the epoxy group, ranges from 0.8 to 1.25, preferably from 0.9 to 1.1. If the mixing ratio is outside the aforesaid range, quality of a cured product and a semiconductor device comprising the cured product may be adversely affected due to unreacted component.

### (C) Thermoplastic resin particles

The present composition is characterized in that it contains (C) thermoplastic res in particles. The particles are solid at a temperature of 25 deg. C. That is, they are not miscible with the epoxy resin (A) at a temperature where the composition is stored or applied on a substrate.

Examples of the thermoplastic resin include AAS resins, AES resins, AS resins, ABS resins, MBS resins, vinyl chloride resins, vinyl acetate resins,(meth)acrylic resins, phenoxy resins, polybutadiene resins, various fluoro-resins, silicone resins, polyacetals, various polyamides, polyamide-imides, polyimides, polyether-imides, polyether ether ketones, polyethylene, polyethylene oxide, polyethylene terephthalate, polycarbonate, polystyrene, polysulfone, polyether sulfone, polyvinyl alcohol, polyvinyl ether, polyvinyl butyral, polyvinyl formal, polyphenylene ether, polyphenylene sulfide, polybutylene terephthalate, polypropylene, and polymethyl pentene.

Among these, (meth) acrylic resins, phenoxy resins, polybutadiene resins, polystyrene and copolymers thereof are preferred. The particle may have a core-shell structure where the core and the shell each consist of different resins. Preferably, the core is a rubber particle composed of a silicone resin, a fluororesin, or a polybutadiene resin, and the shell is composed of a liner thermoplastic resin as those described above.

The thermoplastic resin particles (C) may be spherical or semi-spherical, cylindrical or rectangular cylinder, amorphous, crushed, or flaky. For a die bonding application, preferred are those of spherical or semi-spherical, and amorphous without sharp edges.

An average particle size of the thermoplastic resin particles (C) is preferably selected according to an intended application of the composition. Typically, a maximum particle size, i.e., particle size at cumulative 98% (d98), is 10 m or smaller, preferably 5 m or smaller, and an average particle size, i.e., median size, ranges from 0.1 to 5 m, preferably from 0.1 to 2 m. Particles having a maximum particle size larger than 10 m or an average particle size larger than the aforesaid upper limit may not be swollen or dissolved, which can impair properties of a cured composition. On the other hand, particles having an average particle size smaller than the aforesaid lower limit may cause increased viscosity of a composition which is difficult to handle. Particle size can be measured with an optical microscope or an electron microscope or by laser light diffraction method.

When the described composition is used as a die bonding agent, the maximum particle size is preferably 20 % or smaller of a thickness of the die bonding agent applied on a substrate, and the average particle size is preferably 10% or smaller, more preferably 5% or smaller, of the thickness. Particles having a maximum particle size or an average particle size larger than the aforesaid value may not be swollen or dissolved, which may cause problems such as defects in appearance of a die bonding agent, damages in a chip surface, and electronic leakage.

The thermoplastic resin particles (C) may have a crosslinked structure. However, a degree of the crosslinking is preferably low, because it is desirable that the thermoplastic resin particles are uniformly dispersed in networks formed by the epoxy resin. More preferably, the thermoplastic resin particle (C) is a linear polymer without crosslinkage.

A molecular weight of the thermoplastic resin particles (C) is selected depending on a type of the resin. Typically, a number average molecular weight, reduced to polystyrene, ranges from 10,000 to 10,000,000, preferably from 10,000 to 1,000,000, and a weight average molecular weight ranges from 100,000 to 100,000,000, preferably from 100,000 to 10,000,000. A thermoplastic resin having a number or weight average molecular weight lower than the aforesaid lower limit may has after-mentioned T1, which is a temperature at which an exothermic peak is observed in DSC analysis, too low to have desired stability in A-stage because such a composition can be B-staged at such a low temperature. Further, a die bonding agent in B-stage is not hard enough to prevent formation of voids or shifting or displacement of a silicon die. On the other hand, a thermoplastic resin having a number or weight average molecular weight higher than the aforesaid upper limit may have T1 too high to attain desired stability in B-stage because difference of T2 from T1 is smaller than by 80 °C, that is, T1 is too close to a temperature where the composition becomes C-stage. In addition, a part of such thermoplastic resin particle may hinder formation of a network structure of the epoxy resin after a composition becomes B-stage or C-stage.

In order to attain stable B-stage, the thermoplastic resin particle (C) is contained in the composition in an amount of from 3 to 60, preferably from 5 to 50 parts by weight, more preferably from 10 to 30 parts by weight, per total 100 parts by weight of the epoxy resin (A) and the epoxy resin curing agent (B). With the component (C) less than the aforesaid lower limit, sufficient hardness of B-staged composition may not be attained. Particularly, when the composition is used as a die bonding agent, problems such as formation of voids or a large fillet, and shifting of a silicon die may be caused. On the other hand, with the component (C) more than the aforesaid upper limit, B-staged composition may be too hard, causing adhesion failure when it is used as a die bonding agent.

The thermoplastic resin particle (C) is preferably surface treated. The surface treatment can be performed by any known method using a known surface treatment agent. Preferred examples of the surface treatment agent include silane coupling agents such as vinyltrimethoxysilane, vinyltriethoxysilane, vinyltris(β-methoxyethoxy)silane, β-(3, 4-epoxycyclohexyl) ethyltrimethoxysilane, γ-glycidoxypropyltrimethoxysilane, γ-glycidoxypropyltridiethoxysilane, γ-glycidoxypropyltriethoxysilane, γ-methacryloxypropylmethyldimethoxysilane, γ-methacryloxypropyltrimethoxysilane, γ-methacryloxypropylmethyldiethoxysilane, γ-methacryloxypropyltriethoxysilane, N-β(aminoethyl)γ-aminopropylmethyldimethoxysilane, N-β(aminoethyl)γ-aminopropyltrimethoxysilane, N-β(aminoethyl)γ-aminopropyltriethoxysilane, γ-aminopropyltrimethoxysilane, γ-aminopropyltriethoxysilane, N-phenyl-γ-aminopropyltrimethoxysilane, and γ-mercaptopropyltrimethoxysilane, among which vinyltrimethoxysilane, γ-methacryloxypropyltrimethoxysilane, γ-glycidoxypropyltrimethoxysilane, γ-aminopropyltrimethoxysilane, N-phenyl-γ-aminopropyltrimethoxysilane, and γ-mercaptopropyltrimethoxysilane are preferred.

For the surface treatment, either dry process or wet process can be employed. An amount of the silane coupling agent to be used for the surface treatment ranges from 0.1 to 5 parts by weight per 100 parts by weight of the particles.

### (D) Curing promoter

A known curing promoter can be used, for example, organic phosphorous compounds, imidazols, and tertiary amine compounds. Examples of the organic phosphorous compounds include triphenylphosphine, trubutylphosphine, tri(p-tolyl) phosphine, tri(p-methoxyphenyl)phosphine, tri(p-ethoxyphenyl)phosphine, triphenylphosphine-triphenylborate derivatives, and tetraphenylphosphine-tetraphenylborate derivatives. Examples of imidazol include 2-methylimidazol, 2-ethylimidazol, 2-ethyl-4-methylimidazol, 2-phenylimidazol, 2-phenyl-4-methylimidazol, 2-phenyl-4-methyl-5-hydroxymethylimidazol, and 2-phenyl-4,5-dihyroxymethylimidazol. Examples of tertiary amine include triethylamine, benzyldimethylamine, α-methylbenzyldimethyl amine, and 1,8-diazabicyclo(5, 4, 0) undecene -7. Among these, tetraphenylphosphine-tetraphenylborate derivatives, or methyrol imidazol derivatives are preferably used in combination with the phenolic resin curing agent.

The curing promoter(D) is incorporated in the composition preferably in an amount of from 0.1 to 10 parts by weight, particularly 0.2 to 5 parts by weight, per total 100 parts by weight of the epoxy resin (A) and the epoxy resin curing agent (B). With the curing promoter (D) less than the aforesaid lower limit, curing of the composition may be insufficient. If the curing promoter (D) is contained more than the aforesaid upper limit, storage stability of the composition or storage stability of a B-staged composition may be worse.

When a phenolic resin is used as the curing agent (B), the curing promoter (D) is preferably selected from tetraphenylphosphine-tetraphenylborate and derivatives thereof represented by the following formula (1) and imidazol, particularly methylol imidazol derivatives represented by the following formula (2): 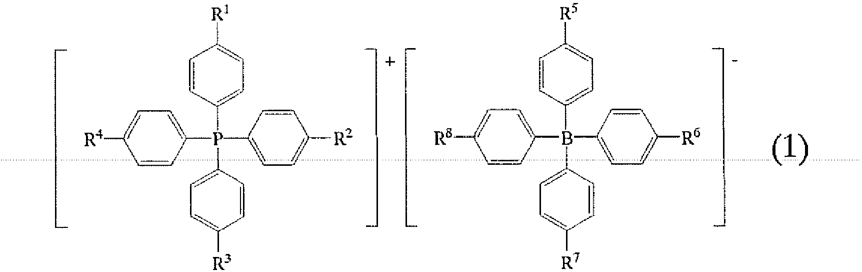 wherein R¹ to R⁸, which may be the same or different, are hydrogen atoms, hydrocarbon groups having 1 to 10 carbon atoms, or halogen atoms; 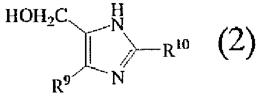 wherein R⁹ is a methyl or methylol group, and R¹⁰ is a hydrocarbon group having 1 to 10 carbon atoms.

### Inorganic filler

The present composition preferably contains inorganic filler particularly when it is used as a die bonding agent. Known inorganic fillers can be used, for example, fused silica, crystallized silica, alumina, titanium oxides, silica titania, boron nitride, aluminum nitride, silicon nitride, magnesia, magnesium silicate, talc, and mica. A mixture of two or more of these can be used. Preferably, at least one selected from silica, alumina and talc is used.

When the present composition is used as a die bonding agent, the inorganic filler preferably has a maximum particle size of at most 20 %, particularly at most 10 %, of a thickness of applied die bonding agent, and has an average particle size of at most 10%, particularly 5%, of a thickness of applied die bonding agent. Inorganic filler having a maximum particle size or an average particle size larger than the aforesaid size may damage a silicon chip, substrate, or gold wire, or cause stress at an interface between the inorganic filler and its surrounding, which may impair capability of a semiconductor device.

Surface of the inorganic filler is preferably pretreated with a silane coupling agent. More preferably, the epoxy resin (A) and the surface-treated inorganic filler are premixed at a reduced pressure, whereby the surface of the inorganic filler is thoroughly wet by the epoxy resin, leading to significantly improved moisture resistance.

Examples of the silane coupling agent include γ-glycidoxypropyltrimethoxysilane, γ-glycidoxypropylmethyldiethoxysilane, γ-glycidoxypropyltriethoxysilane, p-styryltrimethoxysilane, γ-methacryloxypropylmethyldimethoxysilane, γ-methacryloxypropyltrimethoxysilane, γ-methacryloxypropylmethyldiethoxysilane, γ-methacryloxypropyltriethoxysilane, γ-acryloxypropyltrimethoxysilane, N-β(aminoethyl)γ-aminopropylmethyldimethoxysilane, N-β(aminoethyl)γ-aminopropyltrimethoxysilane, N-β(aminoethyl)γ-aminopropyltriethoxysilane, γ-aminopropyltrimethoxysilane, γ-aminopropyltriethoxysilane, N-phenylγ-aminopropyltrimethoxysilane, γ-mercaptopropylmethyldimethoxysilane, γ-mercaptopropyltrimethoxysilane, bis(triethoxypropyyl)tetrasulfide, and γ-isocyanate propyltriethoxysilane. A mixture of two or more of these can be used. Among these, γ-glycidoxypropyltrimethoxysilane is preferred.

Preferred inorganic filler is silica and is incorporated in the composition in an amount of from 1 to 400 parts by weight, preferably from 10 to 200 parts by weight per total 100 parts by weight of the components (A) to (D).

### Optional components

In addition to the aforesaid components, the present composition can contain an optional additive in such an amount that it does not adversely affect the composition. Examples of the additives include silane coupling agents, flame retardants, ion trapping agents, wax, colorants, and adhesion aids.

Examples of the silane coupling agent include γ-glycidoxypropyltrimethoxysilane, γ-glycidoxypropylmethyldiethoxysilane, γ-glycidoxypropyltriethoxysilane, p-styryltrimethoxysilane, γ-methacryloxypropylmethyldimethoxysilane, γ-methacryloxypropyltrimethoxysilane, γ-methacryloxypropylmethyldiethoxysilane, γ-methacryloxypropyltriethoxysilane, γ-acryloxypropyltrimethoxysilane, N-β(aminoethyl)γ-aminopropylmethyldimethoxysilane, N-β(aminoethyl)γ-aminopropyltrimethoxysilane, N-β(aminaethyl)γ-aminopropyltriethoxysilane, γ-aminopropyltrimethoxysilane, γ-aminopropyltriethaxysilane, N-phenylγ-aminopropyltrimethoxysilane, γ-mercaptopropylmethyldimethoxysilane, γ-mercaptopropyltrimethoxysilane, bis(triethoxypropyyl)tetrasulfide, and γ-isocyanate propyltriethoxysilane. A mixture of two or more of these can be used. Among these, γ-glycidoxypropyltrimethoxysilane is preferred.

When the aforesaid coupling agent is used, it is contained in the composition usually in an amount of from 0.1 to 5.0, preferably from 0.3 to 3.0 parts by weight per total 100 parts by weight of the components (A) to (D).

### Preparation of the composition

The present composition can be prepared by mixing components (A), (C), (D), and (B), and aforesaid optional components, if used, with a mixing apparatus such as a mixer, and a roller mill. Sequence of addition of the component, time, temperature and pressure of mixing can by adjusted as necessary.

Preferably, before the aforesaid mixing, volatile substances are removed under a reduced pressure, for example, of 10 mmHg or lower, preferably 5 mmHg or lower. Under the reduced pressure, the components (A), (B) and (D) are kept at a temperature of from 120 to 170 °C, preferably from 140 to 160 °C, for 4 to 8 hours, and the thermoplastic resin particles(C) are kept at a temperature of from 80 to 120 °C for 20 to 30 hours . By this pretreatment, after-mentioned weight loss measured by TGA can be made smaller than a predetermined amount.

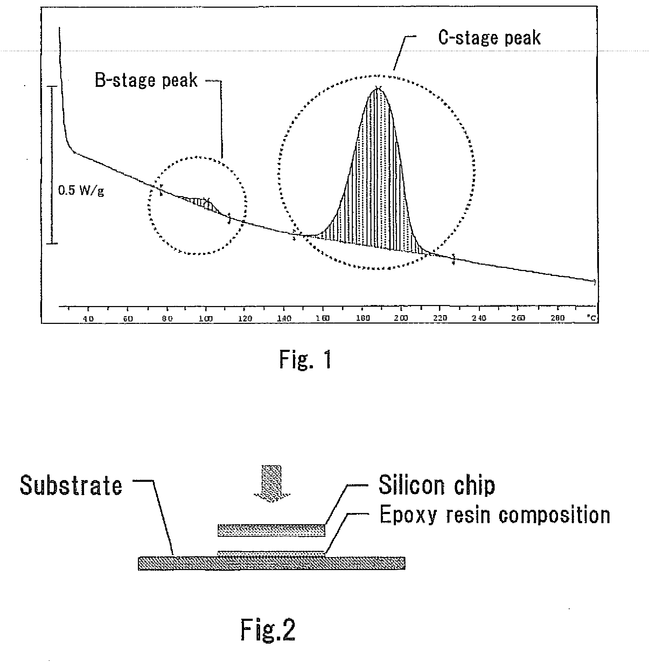

The present composition, when it is analyzed by differential scanning calorimetry (DSC), shows at least one exothermic peak at a temperature lower than a temperature of an exothermic peak due to curing reaction of the epoxy resin (A), which DSC analysis is performed by heating an aluminum cell containing the composition and an empty aluminum cell as a reference at a temperature rise rate of 10 °C/min from 25°C to 300°C in air. A total calorific value of the exothermic peak at the lower temperature is smaller than that of the exothermic peak due to the epoxy resin (A) curing reaction as shown in Fig.1. During the exothermic reaction at the lower temperature, it was found in an observation with an optical microscope that the thermoplastic resin particles (c) are plasticized and swollen to form B-stage having a partially mixed phase of the particles with the resinous or liquid components in the composition. Preferably, an apex temperature (T1) of the exothermic peak at the lower temperature is 80 °C or higher, preferably 90 °C or higher, and lower than an apex temperature (T2) of the exothermic peak of the curing reaction by 70°C to 110 °C, preferably by 80°C to 100 °C. Because the thermoplastic resin particle (c) and the epoxy resin do not mix at a temperature of from 25 °C to the lower exothermic peak temperature, the composition is stable in A-stage. The exothermic reaction at the lower temperature is not associated with a chemical reaction but with a phase change, and is separated from the curing reaction of the epoxy resin, which is considered to be a reason for B-stage stability of the composition.

Preferably, the present composition loses weight by not more than 1%, more preferably not more than 0.8 %, measured by thermogravimetric analysis (TGA) which is performed by heating an aluminum cell containing the composition and an empty aluminum cell as a reference at a temperature rise rate of 10 °C/min from 25°C to 300°C in air. The weight loss is mainly due to evaporation of volatile components in the composition. The volatile components include, for example, low molecular weight fraction of the epoxy resin, the curing agent, or the thermoplastic resin particles, and residual solvents used in syntheses of other components. The aforesaid amount of weight loss can be attained by placing each component under a reduced pressure at an elevated temperature for a certain period of time to remove volatiles, if any, as described above. With this treatment, formation of voids by vaporization of the volatiles when the die bonding agent is exposed to a high temperature of from 150 to 200 °C in wire-bonding or resin encapsulation process can be prevented. This allows the die bonding agent to be cured in the wire-bonding and the resin encapsulation processes, leading to a reduced process time.

Preferably, the present composition has a viscosity of from 10 to 1,000 Pa·s, particularly from 50 to 500 Pa·s, at a temperature of from 150°C to 200 °C, measured with a rheometer while heating the composition from 25°C to 300°C at a temperature rise rate of 10 °C/min in air. A composition having a viscosity at a temperature of from 150°C to 200 °C less than the aforesaid lower limit may cause a chip placed thereon to drift during a wire-bonding or a resin encapsulation process due to softened composition at a temperature of from 150°C to 200 °C. On the other hand, a composition having a viscosity at a temperature of from 150°C to 200 °C higher than the aforesaid upper limit may be too hard to fix a chip thereon. With the viscosity in the aforesaid range, the present composition can provide a cured product with no or little voids even when the curing reaction proceeds during the wire-bonding and resin encapsulation processes.

Conditions for bringing the composition to B-stage composition can be selected as desired, but preferably performed by heating the composition at a temperature of from T1 to T2, particularly from T1 to (T2-20 °C), in order to achieve desired stability of B-staged composition. A time of heating will be selected according to the heating temperature. That is, the higher the heating temperature is, the shorter the heating time is. Heating at a low temperature for a short period of time, particularly in the die bonding agent application, may cause failures such as formation of voids or large fillet, and die shifting. On the other hand, heating at a high temperature for a long period of time may make the composition partly in C-stage, which may cause a problem such as weak adhesion to a die.

Conditions for chip bonding can be selected as desired. Major factors include temperature and time of preheating immediately before bonding a chip, temperature and time of a chip and a substrate, and pressure of bonding. The preheating is intended to remove moisture from a substrate and a die bonding agent, and to soften the die bonding agent to improve adhesion between a chip and the die bonding agent. The preheating is preferably performed at a temperature of from 50 to 150 °C for 10 seconds to 10 minutes. Preferably, a temperature of a chip ranges from 25 to 250 °C and that of a substrate ranges from 25 to 200°C, and the bonding is performed at a pressure of from 0.01 MPa to 10 MPa for 0.01 to 10 seconds.

The present composition is particularly suitable as a die bonding agent for semiconductor devices. The semiconductor devices may be of any design, and particularly suitable for those in which precise and efficient mounting or stacking of large-scaled chips is required.

### EXAMPLES

### Examples 1-11, Referential Example 1, Comparative Examples 1-4

Compositions were prepared by mixing the components in the amounts as shown in Tables 1 and 2 with a planetary mixer at 25 °C which were then passed in a three-roller mill 25 °C followed by re-mixing with a planetary mixer at 25 °C. In Tables 1 and 2, letters "a" to "o" represent materials as shown below and numerals represents amounts in parts by weight. In Tables, "Ex." stands for Example, "Comp. Ex." stands for Comparative Example, and "Ref. Ex." stands for Referential Example.

### (A)Epoxy resin

Epoxy resin (a) : Bisphenol-A type epoxy resin having an epoxy equivalent of 180, sold under the trade name of RE310S from Nihon Kayaku, Co., Ltd.

Silicone-modified epoxy resin (m) prepared in Preparation Example 1

Silicone-modified epoxy resin (o) prepared in Preparation Example 3

### (B) Curing agent

Curing agent (b): Phenol novolac resin having an epoxy equivalent of 110 sold under the trade name of LD92 from Meiwa Plastic Industries, Ltd.

Silicone-modified curing agent (n) prepared in Preparation Example 2

### (C) Thermoplastic resin particles

Thermoplastic resin particles (e) treated as described in Treatment Example 1

Thermoplastic resin particles (f) treated as described in Treatment Example 2

Thermoplastic resin particles (g) treated as described in Treatment Example 3

Thermoplastic resin particles (h) treated as described in Treatment Example 4

Thermoplastic resin particles (i) treated as described in Treatment Example 5

Thermoplastic resinparticles (j) treated as described in Treatment Example 6

Thermoplastic resin particles (k) treated as described inTreatment Example 7

Thermoplastic resin particles (1): Poly(methyl methacrylate) having a number average molecular weight of 500, 000, a weight average molecular weight of 1,500,000, an average particle size of 1µm and a maximum particle size of 3µm

### (D) Curing promoter

Curing promoter (c) : Ttetraphenylphosphine-tetraphenylborate sold under the trade name of TPP-K from Hokko Chemical Industry Co., Ltd.

Curing promoter (d) : Triphenylphosphine sold under the trade name of TPP from Hokko Chemical Industry Co., Ltd.

### Inorganic filler

Silica: Spherical fused silica having an average particle size of 0.8µm, maximum particle size of 3µm sold under the trade name of SE2030 from Admatechs Co.,Ltd

Carbon black sold under the trade name of Denka Black from Denka Co.

Silane coupling agent sold under the trade name of KBM-403 from Shin-Etsu Chemical Co., Ltd.

### Synthesis of silicone-modified resins

### Preparation Example 1

In a flask equipped with a stirring blade, a dropping funnel, a thermometer, an ester adapter and a reflux condenser, 42.0 g(0.10 mole) of the epoxy resin of the formula (12) shown below and 168.0 g of toluene were placed and subjected to azeotropic dehydration at 130 °C for 2 hours. After cooling the mixture of the epoxy resin and toluene to 100 °C, 0.5 g of a catalyst, CAT-PL-50T, ex Shin-Etsu Chemical Co.,Ltd, was added dropwise to the mixture. Immediately after the completion of the addition, a mixture of 36.3 g(0.05 mole) of the organopolysiloxane of the formula (15) shown below and 145.2 g of toluene was added dropwise in about 30 minutes and then heated at 100 °C for 6 hours. By removing toluene, transparent yellowish liquid, hereinafter referred to as silicone-modified epoxy resin (m), was obtained which had a viscosity of 5 Pa·s at 25 °C, an epoxy equivalent of 400 and an organopolysiloxane content of 46.4 parts by weight.

### Preparation Example 2

In a flask equipped with a stirring blade, a dropping funnel, a thermometer, an ester adapter and a reflux condenser, 30.8 g(0.10 mole) of the phenolic resin of the formula (13) shown below and 123.2 g of toluene were placed and subjected to azeotropic dehydration at 130 °C for 2 hours. After cooling the mixture of the phenolic resin and toluene to 100 °C, 0.5 g of a catalyst, CAT-PL-50T, ex Shin-Etsu Chemical Co.,Ltd, was added dropwise to the mixture. Immediately after the completion of the addition, a mixture of 36.3 g(0.05 mole) of the organopolysiloxane of the formula (15) shown below and 145.2 g of toluene was added dropwise in about 30 minutes and then heated at 100 °C for 6 hours. By removing toluene, transparent brownish liquid , hereinafter referred to as silicone-modified curing agent (n), was obtained which had a viscosity of 20 Pa·s at 25 °C, a phenolic equivalent of 340 and an organopolysiloxane content of 54.1 parts by weight.

### Preparation Example 3

In a flask equipped with a stirring blade, a dropping funnel, a thermometer, an ester adapter and a reflux condenser, 68.8 g(0.021 mole) of the epoxy resin of the formula (14) shown below and 275.2 g of toluene were placed and subjected to azeotropic dehydration at 130 °C for 2 hours. After cooling the mixture of the epoxy resin and toluene to 100 °C, 0.5 g of a catalyst, CAT-PL-50T, ex Shin-Etsu Chemical Co.,Ltd, was added dropwise to the mixture. Immediately after the completion of the addition, a mixture of 31.2 g(0.014 mole) of the organopolysiloxane of the formula (16) shown below and 124.8 g of toluene was added dropwise in about 30 minutes and then heated at 100 °C for 6 hours. By removing toluene, opaque white solid, hereinafter referred to as silicone-modified epoxy resin (o), was obtained which having an epoxy equivalent of 290 and an organopolysiloxane content of 31.2 parts by weight. 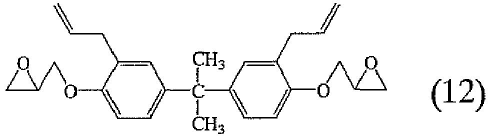 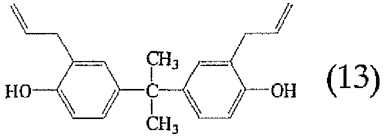 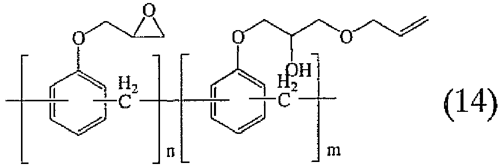 (n/m=1/19, n+m is 5 on average)

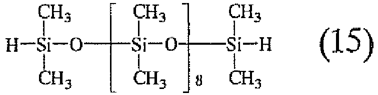

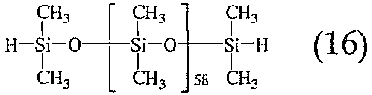

### Treatment of the thermoplastic resin particles

### Treatment Example 1

In a flask equipped with a stirring blade, a dropping funnel, a thermometer and a reflux condenser, 100 g of thermoplastic resin particles of poly(methyl methacrylate) having a number average molecular weight of 500,000, a weight average molecular weight of 1,500,000, an average particle size of 1µm and a maximum particle size of 3µm and 900 g of water were placed and thoroughly stirred at 25 °C to make a homogeneous slurry. In a separate flask equipped with a stirring blade, a dropping funnel, a thermometer and a reflux condenser, 100 g of water was placed and stirred, to which 2 g of silane coupling agent (γ-methacryloxypropyltrimethoxysilane) was added dropwise in about 10 minutes and kept at 25 °C for 2 hours. The aqueous solution of the silane coupling agent thus obtained was added dropwise to the slurry of the thermoplastic resin particles in about 30 minutes and kept at 25 °C for 12 hours. The white particles, hereinafter referred to as thermoplastic resin particle (e), were obtained by removing water.

### Treatment Example 2

In a flask equipped with a stirring blade, a dropping funnel, a thermometer and a reflux condenser, 100 g of thermoplastic resin particles of poly(methyl methacrylate) having a number average molecular weight of 500,000, a weight average molecular weight of 1,500,000, an average particle size of 1µm and a maximum particle size of 3µm and 900 g of water were placed and thoroughly stirred at 25 °C to make homogeneous slurry. In a separate flask equipped with a stirring blade, a dropping funnel, a thermometer and a reflux condenser, 100 g of water was placed and stirred, to which 2 g of silane coupling agent (γ-glycidoxypropyltrimethoxysilane) was added dropwise in about 10 minutes and kept at 25 °C for 2 hours. The aqueous solution of the silane coupling agent thus obtained was added dropwise to the slurry of the thermoplastic resin particles in about 30 minutes and kept at 25 °C for 12 hours. The white particles, hereinafter referred to as thermoplastic resin particle (f), were obtained by removing water.

### Treatment Example 3

In a flask equipped with a stirring blade, a dropping funnel, a thermometer and a reflux condenser, 100 g of thermoplastic resin particles of poly(methyl methacrylate) having a number average molecular weight of 500,000, a weight average molecular weight of 1,500,000, an average particle size of 1µm and a maximum particle size of 3µm and 900 g of water were placed and thoroughly stirred at 25 °C to make a homogeneous slurry. In a separate flask equipped with a stirring blade, a dropping funnel, a thermometer and a reflux condenser, 100 g of water was placed and stirred, to which 2 g of silane coupling agent (N-phenyl-γ-aminopropyltrimethoxysilane) was added dropwise in about 10 minutes and kept at 25 °C for 2 hours. The aqueous solution of the silane coupling agent thus obtained was added dropwise to the slurry of the thermoplastic resin particles in about 30 minutes and kept at 25 °C for 12 hours. The white particles, hereinafter referred to as thermoplastic resin particle (g), were obtained by removing water.

### Treatment Example 4

In a flask equipped with a stirring blade, a dropping funnel, a thermometer and a reflux condenser, 100 g of thermoplastic resin particles of poly(methyl methacrylate) having a number average molecular weight of 50,000, a weight average molecular weight of 150,000, an average particle size of 1µm and a maximum particle size of 3µm and 900 g of water were placed and thoroughly stirred at 25 °C to make a homogeneous slurry. In a separate flask equipped with a stirring blade, a dropping funnel, a thermometer and a reflux condenser, 100 g of water was placed and stirred, to which 2 g of silane coupling agent (γ-methacryloxypropyltrimethoxysilane) was added dropwise in about 10 minutes and kept at 25 °C for 2 hours. The aqueous solution of the silane coupling agent thus obtained was added dropwise to the slurry of the thermoplastic resin particles in about 30 minutes and kept at 25 °C for 12 hours. The white particles, hereinafter referred to as thermoplastic resin particle (h), were obtained by removing water.

### Treatment Example 5

In a flask equipped with a stirring blade, a dropping funnel, a thermometer and a reflux condenser, 100 g of thermoplastic resin particles of core-shell type with butadiene core and partly crosslinked poly(methyl methacrylate) shell having an average particle size of 1µm and a maximum particle size of 3µm and 900 g of water were placed and thoroughly stirred at 25 °C to make a homogeneous slurry. In a separate flask equipped with a stirring blade, a dropping funnel, a thermometer and a reflux condenser, 100 g of water was placed and stirred, to which 2 g of silane coupling agent (γ-methacryloxypropyltrimethoxysilane) was added dropwise in about 10 minutes and kept at 25 °C for 2 hours. The aqueous solution of the silane coupling agent thus obtained was added dropwise to the slurry of the thermoplastic resin particles in about 30 minutes and kept at 25 °C for 12 hours. The white particles, hereinafter referred to as thermoplastic resin particle (i), were obtained by removing water.

### Treatment Example 6

In a flask equipped with a stirring blade, a dropping funnel, a thermometer and a reflux condenser, 100 g of thermoplastic resin particles of polystyrene having a number average molecular weight of 100,000, a weight average molecular weight of 300, 000, an average particle size of 1µm and a maximum particle size of 3µm and 900 g of water were placed and thoroughly stirred at 25 °C to make a homogeneous slurry. In a separate flask equipped with a stirring blade, a dropping funnel, a thermometer and a reflux condenser, 100 g of water was placed and stirred, to which 2 g of silane coupling agent (p-styryltrimethoxysilane) was added dropwise in about 10 minutes and kept at 25 °C for 2 hours. The aqueous solution of the silane coupling agent thus obtained was added dropwise to the slurry of the thermoplastic resin particles in about 30 minutes and kept at 25 °C for 12 hours. The white particles, hereinafter referred to as thermoplastic resin particle (j), were obtained by removing.

### Treatment Example 7

In a flask equipped with a stirring blade, a dropping funnel, a thermometer and a reflux condenser, 100 g of thermoplastic resin particles of poly(methyl methacrylate) having a number average molecular weight of 3,000, a weight average molecular weight of 9,000, an average particle size of 1µm and a maximum particle size of 3µm and 900 g of water were placed and thoroughly stirred at 25 °C to make a homogeneous slurry. In a separate flask equipped with a stirring blade, a dropping funnel, a thermometer and a reflux condenser, 100 g of water was placed and stirred, to which 2 g of silane coupling agent (γ-methacryloxypropyltrimethoxysilane) was added dropwise in about 10 minutes and kept at 25 °C for 2 hours. The aqueous solution of the silane coupling agent thus obtained was added dropwise to the slurry of the thermoplastic resin particles in about 30 minutes and kept at 25 °C for 12 hours. The white particles, hereinafter referred to as thermoplastic resin particle (k), were obtained by removing water.

The compositions were tested according to the following methods. Results are as shown in Tables 3 and 4. In the tables, "ND" stands for "not detected" and "NA" stands for "not available", that is, test pieces could not be obtained because a curing reaction proceeded too much to bond a silicon chip.

### Evaluation methods

### (a) DSC peak temperature

Using a differential scanning calorimeter, ex Mettler, DSC analysis was carried out by heating about 10 mg of a composition in an aluminum cell or pan and an empty aluminum cell as a reference at a temperature rise rate of 10 °C/min from 25 °C to 300 °C in air.

### (b) Storage stability in A-stage

Viscosity of a composition was measured immediately after the composition was prepared and after it was stored at 25 °C for predetermined periods of time as shown in Tables 3 and 4.

### (c) Storage stability in B-stage

Ten milligrams of a composition was B-staged by heating the composition at a temperature higher than its T1 by 20 °C. The compositions of Comparative Examples 1 to 4 were B-staged at 120 °C. The B-stage composition was analyzed by DSC in the same manner as in the test (a) immediately after the composition was B-staged and after the B-staged composition was stored at 25 °C for predetermined periods of time shown in Tables 3 and 4. A ratio of an exothermic peak area of a composition after stored to that of the composition immediately after B-staged was calculated.

### (d) Voids

A test piece as shown in Fig.2 was prepared. Total 20 pieces were prepared and observed with a Scanning Acoustic Tomograph (SAT) . Test pieces in which a void was detected were counted. The test piece was prepared by the following method:
An epoxy resin composition was applied in a size of 12 mm x 12mm x 50µm on a 35 mm x 35 mm x 200 µm-BT substrate coated with 30-µm thick solder resist. The applied composition was B-staged by heating at a temperature higher than its T1 by 20 °C, except the compositions of Comparative Examples 3-6 which were B-staged at 120 °C, for 10 minutes. On the B-staged composition, a 12.5 mm x 12.5 mm x 3 00 µm-silicon chip coated with boron nitride layer was bonded at a pressure of 1 MPa and at a temperature of 150 °C for 1 second.

### (e) Voids after B-stage

A test piece was prepared in the same manner as above except that a chip was bonded after the B-staged composition was left stand at 25 °C for the periods of time shown in Tables 3 and 4. Total 20 test pieces were observed with SAT and test pieces in which a void was detected were counted.

### (f) Fillet after bonding a chip

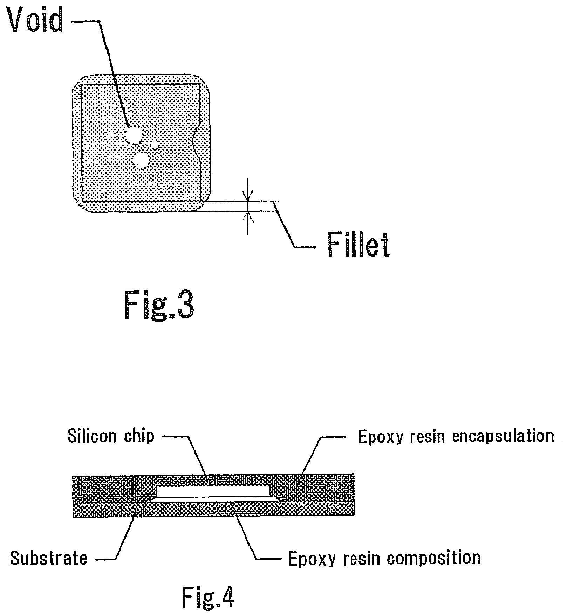

A maximum width of a fillet, which is exuded composition from sides of a silicon chip, as schematically illustrated in Fig.3, was measured for 20 test pieces prepared in the test (d). The width is preferably 100µm or smaller, because a wider fillet requires a longer distance between a chip and wire bonding pads on a substrate. Test pieces having fillets wider than 100µm were counted.

### (g) Fillet after B-stage

A maximum width of a fillet was measured in the same manner as in the test (f) for 20 test pieces prepared in the test (e). Test pieces having fillets wider than 100µm were counted.

**Table 1**

| | Ex.1 | Ex.2 | Ex.3 | Ex.4 | Ex.5 | Ex.6 | Ex.7 | Ex.8 | Ex.9 | Ex.10 | Ex.11 |
|---|---|---|---|---|---|---|---|---|---|---|---|
| (A)Epoxy resin | a | a | a | a | a | a | m | a/o | a | a | a |
| | 34.6 | 34.6 | 34.6 | 34.6 | 34.6 | 34.6 | 78.4 | 50.3/13.7 | 34.6 | 34.6 | 34.6 |
| (B)Curing agent | n | n | n | n | n | n | b | b | n | n | n |
| | 65.4 | 65.4 | 65.4 | 65.4 | 65.4 | 65.4 | 21.6 | 36 | 65.4 | 65.4 | 65.4 |
| (D)Curing promoter | c | c | c | c | c | c | c | c | c | c | c |
| | 1 | 1 | 1 | 1 | 1 | 1 | 1 | 1 | 1 | 1 | 1 |
| (C)Themoplastic resin particles | e | f | g | h | i | j | e | e | 1 | e | e |
| | 20 | 20 | 20 | 20 | 20 | 20 | 20 | 20 | 20 | 3 | 60 |
| Silica | 123.5 | 123.5 | 123.5 | 123.5 | 123.5 | 123.5 | 123.5 | 123.5 | 123.5 | 106.5 | 163.5 |
| Carbon black | 1 | 1 | 1 | 1 | 1 | 1 | 1 | 1 | 1 | 1 | 1 |
| KBM-403 | 1.5 | 1.5 | 1.5 | 1.5 | 1.5 | 1.5 | 1.5 | 1.5 | 1.5 | 1.5 | 1.5 |

**Table 2**

| | Ref.Ex.1 | Comp.Ex.1 | Comp.Ex.2 | Comp.Ex.3 | Comp.Ex.4 |
|---|---|---|---|---|---|
| (A)Epoxy resin | a | a | m | a | m |
| | 34.6 | 34.6 | 78.4 | 34.6 | 78.4 |
| (B)Curing agent | n | n | b | n | b |
| | 65.4 | 65.4 | 21.6 | 65.4 | 21.6 |
| (D)Curing promoter | c | c | c | d | d |
| | 1 | 1 | 1 | 1 | 1 |
| (C)Themoplastic resin particles | k | 0 | 0 | 0 | 0 |
| | 20 | | | | |
| Silica | 123.5 | 123.5 | 123.5 | 123.5 | 123.5 |
| Carbon black | 1 | 1 | 1 | 1 | 1 |
| KBM-403 | 1.5 | 1.5 | 1.5 | 1.5 | 1.5 |

**Table 3**

| | | Ex.1 | Ex.2 | Ex.3 | Ex.4 | Ex.5 | Ex.6 | Ex.7 | Ex.8 | Ex.9 | Ex.10 | Ex.11 |
|---|---|---|---|---|---|---|---|---|---|---|---|---|
| (a) DSC | T1°C | 98 | 100 | 99 | 85 | 97 | 105 | 102 | 103 | 114 | 102 | 94 |
| | T2°C | 190 | 191 | 187 | 191 | 192 | 189 | 202 | 205 | 189 | 187 | 193 |
| (b) A-stage storage stability | 1 day | 101 | 101 | 102 | 102 | 101 | 100 | 101 | 101 | 101 | 101 | 104 |
| | 2 days | 103 | 102 | 105 | 104 | 103 | 102 | 103 | 103 | 102 | 101 | 109 |
| | 3 days | 106 | 105 | 110 | 109 | 108 | 104 | 105 | 105 | 103 | 102 | 118 |
| | 7 days | 112 | 110 | 116 | 118 | 117 | 108 | 110 | 109 | 105 | 105 | 132 |
| (c) B-stage storage stability | 4 weeks,% | 97.4 | 97.2 | 96.7 | 97.9 | 97.2 | 96.7 | 98.1 | 97.9 | 97.2 | 97.5 | 99.1 |
| | 8 weeks,% | 96.5 | 95.9 | 95.4 | 97.3 | 96.2 | 95.6 | 97.8 | 97.5 | 96.3 | 96.8 | 98.5 |
| | 16 weeks, % | 96 | 95.7 | 95.3 | 96.8 | 96 | 95.5 | 97.5 | 97.3 | 95.5 | 96.3 | 97.8 |
| | 24 weeks,% | 96.1 | 95.5 | 95.2 | 96.7 | 95.8 | 95.1 | 97.2 | 96.9 | 94.8 | 96 | 97.3 |
| (d) Voids | | 0/20 | 0/20 | 0/20 | 0/20 | 0/20 | 0/20 | 0/20 | 0/20 | 0/20 | 0/20 | 20/20 |
| (e) Voids after B-stage | 4 weeks,% | 0/20 | 0/20 | 0/20 | 0/20 | 0/20 | 0/20 | 0/20 | 0/20 | 0/20 | 0/20 | 20/20 |
| | 8 weeks,% | 0/20 | 0/20 | 0/20 | 0/20 | 0/20 | 0/20 | 0/20 | 0/20 | 0/20 | 0/20 | 20/20 |
| | 16 weeks, % | 0/20 | 0/20 | 0/20 | 0/20 | 0/20 | 0/20 | 0/20 | 0/20 | 1/20 | 0/20 | 20/20 |
| | 24 weeks,% | 0/20 | 0/20 | 0/20 | 0/20 | 0/20 | 0/20 | 0/20 | 0/20 | 3/20 | 0/20 | 20/20 |
| (f) Fillet | | 0/20 | 0/20 | 0/20 | 0/20 | 0/20 | 0/20 | 0/20 | 0/20 | 0/20 | 19/20 | 0/20 |
| (g) Fillet after B-stage | 4 weeks,% | 0/20 | 0/20 | 0/20 | 0/20 | 0/20 | 0/20 | 0/20 | 0/20 | 0/20 | 17/20 | 0/20 |
| | 8 weeks, % | 0/20 | 0/20 | 0/20 | 0/20 | 0/20 | 0/20 | 0/20 | 0/20 | 0/20 | 15/20 | 0/20 |
| | 16 weeks,% | 0/20 | 0/20 | 0/20 | 0/20 | 0/20 | 0/20 | 0/20 | 0/20 | 0/20 | 14/20 | 0/20 |
| | 24 weeks, % | 0/20 | 0/20 | 0/20 | 0/20 | 0/20 | 0/20 | 0/20 | 0/20 | 0/20 | 14/20 | 0/20 |

**Table 4**

| | | Ref.Ex.1 | Comp.Ex.1 | Comp.Ex.2 | Comp.Ex.3 | Comp.Ex.4 |
|---|---|---|---|---|---|---|
| (a) DSC | T1°C | 75 | ND | ND | ND | ND |
| | T2°C | 192 | 185 | 198 | 132 | 125 |
| (b) A-stage storage stability | 1 day | 103 | 100 | 100 | 104 | 110 |
| | 2 days | 105 | 101 | 100 | 108 | 132 |
| | 3 days | 112 | 102 | 101 | 126 | 175 |
| | 7 days | 128 | 102 | 101 | 182 | 258 |
| (c) B-stage storage stability | 4 weeks,% | 98.1 | 96.9 | 97.8 | 79.4 | 72.1 |
| | 8 weeks, % | 97.4 | 95.9 | 96.9 | 74.2 | 63.5 |
| | 16 weeks, % | 97.1 | 95.0 | 96.2 | 70.2 | 53.8 |
| | 24 weeks, % | 96.8 | 94.3 | 95.1 | 65.2 | 45.3 |
| (d) Voids | | 0/20 | 0/20 | 0/20 | 0/20 | 0/20 |
| (e) Voids after B-stage | 4 weeks, % % | 0/20 | 0/20 | 0/20 | NA | NA |
| | 8 weeks,% | 0/20 | 0/20 | 0/20 | NA | NA |
| | 16 weeks, % | 0/20 | 0/20 | 0/20 | NA | NA |
| | 24 weeks,% | 0/20 | 0/20 | 0/20 | NA | NA |
| (f) Fillet | | 0/20 | 20/20 | 20/20 | 0/20 | 0/20 |
| (g) Fillet after B-stage | 4 weeks,% | 15/20 | 20/20 | 20/20 | NA | NA |
| | 8 weeks,% | 12/20 | 20/20 | 20/20 | NA | NA |
| | 16 weeks,% | 5/20 | 20/20 | 20/20 | NA | NA |
| | 24 weeks, % | 3/20 | 20/20 | 20/20 | NA | NA |

As shown in Tables 3 and 4, the described compositions were stable in A-stage, showing less than 30% increase in viscosity in A-stage. The B-stage compositions which had been stored for certain period of time after it was brought to B-stage showed 95 % or more of the exothermic heat of that measured immediately after B-staged, indicating good storage stability in B-stage, i.e., no procession of curing reaction. The compositions of Comparative Examples 1 and 2 incurred voids or fillets when a chip was bonded after they had been stored in B-stage, although about 95% of exothermic heat was maintained. The present composition did not incur any void or fillet even after stored in B-stage for a certain period of time.

### Examples 12-17

### Preparation of compositions

Compositions were prepared by mixing the components in the amounts as shown in Table 5 with a planetary mixer and then passing the mixture in a three-roller mill followed by re-mixing with a planetary mixer at 25 deg. C. Before the preparation, volatiles were removed by placing the epoxy resins, curing agents and curing promoters in a vacuum oven at 150 deg. C and at 5 mmHg for 6 hours, and by placing the thermoplastic resin particles in a vacuum oven at 100 deg. C and at a pressure of 5 mmHg or lower for 24 hours. In Table 5, the "-" sign indicates the aforesaid removal of volatiles was performed. For example, the epoxy resin "a-" represents the epoxy resin (a) treated in a vacuum oven as described above.

**Table 5**

| | Ex.12 | Ex.13 | Ex. 14 | Ex.15 | Ex.16 | Ex.17 |
|---|---|---|---|---|---|---|
| (A)Epoxy resin | a-34.6 | a-34.6 | a-34.6 | a-34.6 | a-34.6 | a-34.6 |
| (B) Curing agent | n-65.4 | n-65.4 | n-65.4 | n-65.4 | n-65.4 | n-65.4 |
| (D) Curing promoter | c-1 | c-1 | c-1 | c-1 | c-1 | c-1 |
| (C) Themoplastic resin particles | e-20 | e-5 | e-50 | f-20 | g-20 | h-20 |
| Silica | 123.5 | 108.5 | 153.5 | 123.5 | 123.5 | 123.5 |
| Carbon black | 1 | 1 | 1 | 1 | 1 | 1 |
| KBM-403 | 1.5 | 1.5 | 1.5 | 1.5 | 1.5 | 1.5 |

The compositions prepared were tested according to the aforesaid methods (a) to (g) and the following tests (h) to (k). The tests (h) to (k) were also performed on some of the compositions of Examples 1- 11. The results are shown in Tables 6 and 7.

### (h) TGA

Using a thermogravimetric analyzer(TGA), ex Mettler, thermal analysis was carried out by heating 10 mg of an composition in an aluminum cell and an empty aluminum cell as a reference at a temperature rise rate of 10 °C/min from 25 °C to 300 °C in air. A loss in weight (%) observed at a temperature of from 25 to 200 °C was determined.

### (i) Viscosity at a temperature of from 150 °C to 200 °C

Using a rheometer, ex U.B.M. Co., 280 microliter of a composition was placed in 1.12-mm gap between two 18-mm ϕ disks and heated at a temperature rise rate of 10 °C/min from 25 °C to 300 °C. Viscosity at a temperature of from 150 °C to 200 °C was averaged.

### (j) Voids after encapsulation with resin

A test piece as shown in Fig.4 was prepared. Twenty pieces for each composition were prepared and observed with a SAT. Test pieces in which a void was detected were counted. The test piece was prepared by the following method: An epoxy resin composition was applied in a size of 12 mm x 12mm x 50µm on a 35 mm x 35 mm x 200 µm-BT substrate coated with 30-µm thick solder resist. The applied composition was B-staged by heating at a temperature higher than its T1 by 20 °C for 10 minutes. On the B-staged composition, a 12.5 mm x 12.5 mm x 300 µm-silicon chip coated with boron nitride layer was bonded at a pressure of 1 MPa and at a temperature of 150 °C for 1 second. The device obtainedwas encapsulated with an epoxy resin encapsulating agent, KMC-2520, ex Shin-Etsu Chemical Co., Ltd, in the following molding conditions: mold temperature of 175 °C, injection period of 10 seconds, injection pressure of 70 kPa, molding time of 90 seconds, and post curing at 180 °C for 2 hours. The encapsulated test piece measured 35 mm x 35 mm x 1,000 µm.

### (k) Die shift in encapsulated test pieces

Twenty test pieces as shown in Fig. 4 for each composition were observed with a soft X-ray transmission device to detect a shift or displacement of a silicon chip. The shift was determined as a total of linear shift of four corners of the chip. Test pieces were counted which showed a shift greater than 50 µm.

**Table 6**

| | | Ex.12 | Ex.13 | Ex.14 | Ex.15 | Ex.16 | Ex.17 |
|---|---|---|---|---|---|---|---|
| (a) DSC | T1°C | 99 | 104 | 96 | 101 | 100 | 87 |
| | T2°C | 192 | 191 | 193 | 193 | 190 | 194 |
| (b) A-stage storage stability | 1 day | 101 | 100 | 103 | 101 | 102 | 102 |
| | 2 days | 102 | 101 | 107 | 102 | 104 | 103 |
| | 3 days | 105 | 102 | 111 | 104 | 108 | 108 |
| | 7 days | 110 | 104 | 119 | 108 | 114 | 115 |
| (c) B-stage storage stability | 4 week, % | 97.4 | 97.0 | 98.1 | 97.0 | 96.4 | 97.6 |
| | 8 weeks,% | 96.4 | 96.3 | 97.9 | 95.7 | 95.7 | 97.0 |
| | 16 weeks,% | 96.1 | 96.0 | 97.2 | 95.4 | 95.4 | 96.4 |
| | 24 weeks, % | 95.8 | 95.1 | 96.8 | 95.4 | 95.1 | 95.9 |
| (d) Voids | | 0/20 | 0/20 | 0/20 | 0/20 | 0/20 | 0/20 |
| (e) Voids after B-stage | 4 weeks,% | 0/20 | 0/20 | 0/20 | 0/20 | 0/20 | 0/20 |
| | 8 weeks,% | 0/20 | 0/20 | 0/20 | 0/20 | 0/20 | 0/20 |
| | 16 weeks,% | 0/20 | 0/20 | 0/20 | 0/20 | 0/20 | 0/20 |
| | 24 weeks,% | 0/20 | 0/20 | 0/20 | 0/20 | 0/20 | 0/20 |
| (f) Fillet | | 0/20 | 0/20 | 0/20 | 0/20 | 0/20 | 0/20 |
| (g) Fillet after B-stage | 4 weeks,% | 0/20 | 0/20 | 0/20 | 0/20 | 0/20 | 0/20 |
| | 8 weeks,% | 0/20 | 0/20 | 0/20 | 0/20 | 0/20 | 0/20 |
| | 16 weeks,% | 0/20 | 0/20 | 0/20 | 0/20 | 0/20 | 0/20 |
| | 24 weeks,% | 0/20 | 0/20 | 0/20 | 0/20 | 0/20 | 0/20 |

**Table 7**

| | Ex.1 | Ex.2 | Ex.3 | Ex.7 | Ex.8 | Ex.10 | Ex.11 | Ref.Ex.1 |
|---|---|---|---|---|---|---|---|---|
| (h) TGA | 1.5 | 2.1 | 1.2 | 2.6 | 1.9 | 0.6 | 0.9 | 0.8 |
| (i) Viscosity(150-200°C), Pa.s | 210 | 220 | 280 | 350 | 420 | 8.2 | 1020 | 9.4 |
| (j) Voids after encapsulation | 6/20 | 13/20 | 2/20 | 18/20 | 7/20 | 0/20 | 20/20 | 0/20 |
| (k) Die shift | 0/20 | 0/20 | 0/20 | 0/20 | 0/20 | 20/20 | 0/20 | 20**/**20 |

**Table 8**

| | Ex.12 | Ex.13 | Ex.14 | Ex.15 | Ex.16 | Ex.17 |
|---|---|---|---|---|---|---|
| (h) TGA | 0.6 | 0.8 | 0.4 | 0.7 | 0.5 | 0.8 |
| (i) Viscosity (150-200°C), Pa.s | 230 | 12 | 950 | 240 | 320 | 38 |
| (j) Voids after encapsulation | 0/20 | 0/20 | 0/20 | 0/20 | 0/20 | 0/20 |
| (k) Die shift | 0/20 | 0/20 | 0/20 | 0/20 | 0/20 | 0/20 |

The compositions of Examples 12 to 17 showed less than 1% weight loss in TGA in test (h). Their viscosity at a temperature of from 150 °C to 200 °C measured in test (i) ranged from 10 Pa · s to 1,000 Pa · s, and no void or die shift was caused while the curing of the composition proceeded in the encapsulation process.

### INDUSTRIAL APPLICABILITY

The described composition is stable in B-stage and is suitable as a die bonding agent for manufacturing semiconductor devices where a high process yield is required. The composition having a reduced amount of volatiles and a viscosity in a specific range allows one to proceed from a die bonding process to a wire bonding process and then to resin encapsulation process without a curing process, whereby productivity is improved.

## Claims

1. A method of producing a semiconductor device, comprising steps of
1) applying on a substrate a die bonding agent comprising a composition comprising
(A) an epoxy resin,
(B) an epoxy resin curing agent in such an amount that an equivalent ratio of a functional group of the epoxy resin curing agent (B) to the epoxy group of the epoxy resin (A) ranges from 0.8 to 1.25,
(C) thermoplastic resin particles which are solid at 25°C in an amount of from 3 to 60 parts by weight per total 100 parts by weight of the epoxy resin (A) and the epoxy resin curing agent (B), and
(D) an epoxy resin curing promoter in an amount of from 0.1 to 10 parts by weight per total 100 parts by weight of the epoxy resin (A) and the epoxy resin curing agent (B), wherein the composition, when analyzed by differential scanning calorimetry (DSC), shows at least one exothermic peak at a temperature lower than a temperature of an exothermic peak caused by curing of the epoxy resin (A), an apex temperature (T1) of said exothermic peak at the lower temperature being 80 °C or higher and lower than an apex temperature (T2) of the exothermic peak caused by the curing of the epoxy resin (A) by at least 70°C, said DSC analysis being performed by heating an aluminum cell containing the composition and an empty aluminum cell as a reference at a temperature rise rate of 10°C/min from 25°C to 300°C in air,
2) heating the applied die bonding agent at a temperature of from T1 to (T2-20°C) to bring the die bonding agent to a B-stage,
3) placing a semiconductor element on the die bonding agent in the B-stage, and
4) curing the die bonding agent.

2. The method according to claim 1, wherein the thermoplastic resin particles (C) are contained in an amount of from 5 to 50 parts by weight per total 100 parts by weight of the epoxy resin (A) and the epoxy resin curing agent (B).

3. The method according to claim 1 or 2, wherein the thermoplastic resin particles (C) are particles of a thermoplastic resin selected from the group consisting of methacrylic resins, phenoxy resins, butadiene resins, polystyrenes, and copolymers thereof.

4. The method according to any one of claims 1 to 3, wherein the thermoplastic resin particles (C) have a number average molecular weight, reduced to polystyrene, of from 10,000 to 1,000,000, and a weight average molecular weight of from 100,000 to 10,000,000.

5. The method according to any one of claims 1 to 4, wherein the thermoplastic resin particles (C) have a median size of from 0.1 to 5*µ*m and a particle size at cumulative 98% of 10*µ*m or smaller.

6. The method according to any one of claims 1 to 5, wherein the thermoplastic resin particles (C) are surface treated with a silane coupling agent.

7. The method according to any one of claims 1 to 6, wherein the composition further comprises an inorganic filler.

8. The method according to any one of claims 1 to 7, wherein at least a part of the epoxy resin (A) and/or of the epoxy resin curing agent (B) has a silicone residue.

9. The method according to any one of claims 1-8, wherein the composition loses weight by not more than 1%, when analyzed by thermogravimetric analysis (TGA), said TGA analysis being performed by heating an aluminum cell containing the composition and an empty aluminum cell as a reference at a temperature rise rate of 10°C/min from 25°C to 300°C in air, and
the composition has a viscosity of from 10 to 1,000 Pa · s at a temperature of from 150°C to 200°C, said viscosity being measured with a rheometer by heating the composition at a temperature rise rate of 10°C/min from 25°C to 300°C in air.

## Patentansprüche

1. Verfahren zur Herstellung einer Halbleitervorrichtung, umfassend die Schritte des
1) Aufbringens eines Die-Bondingagens auf ein Substrat, umfassend eine Zusammensetzung umfassend
(A) ein Epoxidharz,
(B) einen Epoxidharz-Härter in einer derartigen Menge, dass ein Äquivalentverhältnis einer funktionellen Gruppe des Epoxidharz-Härters (B) zu der Epoxidgruppe des Epoxidharzes (A) von 0,8 bis 1,25 reicht,
(C) thermoplastische Harzpartikel, welche bei 25°C fest sind, in einer Menge von 3 bis 60 Gewichtsteilen pro insgesamt 100 Gewichtsteilen des Epoxidharzes (A) und des Epoxidharz-Härters (B), und
(D) einen Epoxidharz-Härter-Promotor in einer Menge von 0,1 bis 10 Gewichtsteilen pro insgesamt 100 Gewichtsteilen des Epoxidharzes (A) und des Epoxidharz-Härters (B),
wobei die Zusammensetzung, wenn sie mittels Differenzial-Scanning-Kalorimetrie (DSC) analysiert wird, mindestens einen exothermen Peak bei einer Temperatur aufweist, die niedriger ist als eine Temperatur eines exothermen Peaks, der durch Aushärten des Epoxidharzes (A) verursacht wurde, wobei eine Spitzentemperatur (T1) des exothermen Peaks bei der niedrigeren Temperatur 80°C oder höher und um mindestens 70°C niedriger als eine Spitzentemperatur (T2) des exothermen Peaks, der durch das Aushärten des Epoxidharzes (A) verursacht wurde, ist, wobei die DSC-Analyse durchgeführt wird durch Erhitzen einer Aluminiumzelle enthaltend die Zusammensetzung und eine leere Aluminiumzelle als eine Referenz bei einer Temperaturerhöhungsrate von 10°C/min von 25°C bis 300°C in der Luft,
2) Erhitzens des aufgebrachten Die-Bondingagens bei einer Temperatur von T1 bis (T2 - 20°C), um den Die-Bondingagens auf ein B-Stadium zu bringen,
3) Platzierens eines Halbleiter-Elements auf das Die-Bondingagens in dem B-Stadium, und
4) des Aushärtens des Die-Bondingagens.

2. Verfahren gemäß Anspruch 1, wobei die thermoplastischen Harzpartikel (C) in einer Menge von 5 bis 50 Gewichtsteilen pro gesamt 100 Gewichtsteilen des Epoxidharzes (A) und des Epoxidharz-Härters (B) enthalten sind.

3. Verfahren gemäß Anspruch 1 oder 2, wobei die thermoplastischen Harzpartikel (C) Partikeln eines thermoplastischen Harzes ausgewählt aus der Gruppe bestehend aus Methacrylatharze, Phenoxyharze, Butadienharze, Polystryrole und Copolymere davon, sind.

4. Verfahren gemäß irgendeinem der Ansprüche 1 bis 3, wobei die thermoplastischen Harzpartikel (C) ein zahlengemitteltes Molekulargewicht, reduziert auf Polystyrol, von 10000 bis 1000000 aufweisen, und ein gewichtsgemitteltes Molekulargewicht von 100000 bis 10000000.

5. Verfahren gemäß irgendeinem der Ansprüche 1 bis 4, wobei die thermoplastischen Harzpartikel (C) eine mittlere Größe von 0,1 bis 5 µm und eine Partikelgröße bei kumulativen 98% von 10 µm oder kleiner aufweisen.

6. Verfahren gemäß irgendeinem der Ansprüche 1 bis 5, wobei die thermoplastischen Harzpartikel (C) mit einem Silan-Kupplungsagens oberflächenbehandelt sind.

7. Verfahren gemäß irgendeinem der Ansprüche 1 bis 6, wobei die Zusammensetzung ferner einen anorganischen Füllstoff umfasst.

8. Verfahren gemäß irgendeinem der Ansprüche 1 bis 7, wobei mindestens ein Teil des Epoxidharzes (A) und/oder des Epoxidharz-Härters (B) einen Silikonrest aufweist.

9. Verfahren gemäß irgendeinem der Ansprüche 1 bis 8, wobei die Zusammensetzung nicht mehr als 1% Gewicht verliert, wenn analysiert mittels thermogravimetrischer Analyse (TGA), diese TGA-Analyse wird durchgeführt durch Erhitzen einer Aluminiumzelle enthaltend die Zusammensetzung und einer leeren Aluminiumzelle als eine Referenz bei einer Temperaturanstiegsrate von 10°C/min von 25°C bis 300°C in Luft, und
die Zusammensetzung eine Viskosität von 10 bis
1000 Pa · s bei einer Temperatur von 150°C bis 200°C aufweist, diese Viskosität wird mit einem Rheometer gemessen durch Erhitzen der Zusammensetzung bei einer Temperaturanstiegsrate von 10°C/min von 25°C bis 300°C in Luft.

## Revendications

1. Procédé de production d'un dispositif semi-conducteur, comprenant les étapes consistant à :
1) appliquer sur un substrat un agent de liaison de filière comprenant une composition comprenant
(A) une résine époxy,
(B) un agent de durcissement de résine époxy en une quantité telle qu'un rapport d'équivalent d'un groupe fonctionnel de l'agent de durcissement (B) de résine époxy au groupe époxy de la résine époxy (A) est compris dans la plage allant de 0,8 à 1,25,
(C) des particules de résine thermoplastique qui sont solides à 25 °C en une quantité de 3 à 60 parties en poids pour un total de 100 parties en poids de la résine époxy (A) et de l'agent de durcissement (B) de résine époxy, et
(D) un promoteur de durcissement de résine époxy en une quantité de 0,1 à 10 parties en poids pour un total de 100 parties en poids de la résine époxy (A) et de l'agent de durcissement (B) de résine époxy,
dans lequel la composition, lorsqu'elle est analysée par calorimétrie à balayage différentiel (DSC), montre qu'au moins un pic exothermique à une température inférieure à une température d'un pic exothermique provoqué par le durcissement de la résine époxy (A), une température Apex (T1) dudit pic exothermique à la température inférieure étant supérieure ou égale à 80 °C et inférieure à une température Apex (T2) du pic exothermique provoqué par le durcissement de la résine (A) par au moins 70 °C, ladite analyse DSC étant réalisée par chauffage d'une cellule d'aluminium contenant la composition et d'une cellule d'aluminium vide en tant que référence à une vitesse d'augmentation de la température de 10 °C/min de 25 °C à 300 °C dans l'air,
2) chauffer l'agent de liaison de filière appliqué à une température allant de T1 à (T2 - 20 °C) pour amener l'agent de liaison de filière à un stade B,
3) placer un élément semi-conducteur sur l'agent de liaison de filière au stade B, et
4) durcir l'agent de liaison de filière.

2. Procédé selon la revendication 1, dans lequel les particules de résine thermoplastique (C) sont contenues en une quantité de 5 à 50 parties en poids pour un total de 100 parties en poids de la résine époxy (A) et de l'agent de durcissement (B) de résine époxy.

3. Procédé selon la revendication 1 ou 2, dans lequel les particules de résine thermoplastique (C) sont des particules d'une résine thermoplastique choisie dans le groupe constitué par les résines méthacryliques, les résines phénoxy, les résines de butadiène, les polystyrènes et les copolymères de celles-ci.

4. Procédé selon l'une quelconque des revendications 1 à 3, dans lequel les particules de résine thermoplastique (C) ont un poids moléculaire moyen en nombre, réduit au polystyrène, allant de 10 000 à 1 000 000 et un poids moléculaire moyen en poids allant de 100 000 à 10 000 000.

5. Procédé selon l'une quelconque des revendications 1 à 4, dans lequel les particules de résine thermoplastique (C) ont une taille médiane allant de 0,1 à 5 µm et une taille de particules à un cumulatif de 98 % inférieure ou égale à 10 µm.

6. Procédé selon l'une quelconque des revendications 1 à 5, dans lequel les particules de résine thermoplastique (C) ont une surface traitée avec un agent de couplage de silane.

7. Procédé selon l'une quelconque des revendications 1 à 6, dans lequel la composition comprend en outre une charge inorganique.

8. Procédé selon l'une quelconque des revendications 1 à 7, dans lequel au moins une partie de la résine époxy (A) et/ou de l'agent de durcissement (B) de résine époxy comprend un résidu silicone.

9. Procédé selon l'une quelconque des revendications 1 à 8, dans lequel la composition perd du poids à hauteur de pas plus de 1 %, lorsqu'elle est analysée par analyse thermogravimétrique (TGA), ladite analyse TGA étant réalisée par chauffage d'une cellule d'aluminium contenant la composition et d'une cellule d'aluminium vide en tant que référence à une vitesse d'augmentation de la température de 10 °C/min de 25 °C à 300 °C dans l'air, et
la composition a une viscosité allant de 10 à 1000 Pa.s à une température de 150 °C à 200 °C, ladite viscosité étant mesurée avec un rhéomètre en chauffant la composition à une vitesse d'augmentation de la température de 10 °C/min de 25 °C à 300 °C dans l'air.
